# EUROPÄISCHE PATENTANMELDUNG

(11) **EP 0 843 342 A1**
(43) Veröffentlichungstag der Anmeldung: **20.05.1998**
(21) Anmeldenummer: 97119851.0
(22) Anmeldetag: 13.11.1997
(51) Int. Cl.: H01L 21/00, B24B 37/04

(54) **Verfahren und Vorrichtung zum Entfernen einer Halbleiterscheibe von einer ebenen Unterlage**

(30) Priorität: 18.11.1996 DE 19647635
(71) Anmelder: Wacker Siltronic Gesellschaft für Halbleitermaterialien Aktiengesellschaft, 84489 Burghausen (DE)
(72) Erfinder: Pietsch, Georg, Dr., 84489 Burghausen (DE); Feuchtinger, Ernst, 84384 Wittibreut (DE)
(74) Vertreter: Rimböck, Karl-Heinz, Dr.

(57) **Zusammenfassung**

Gegenstand der Erfindung ist ein Verfahren zum Entfernen einer Halbleiterscheibe von einer ebenen Unterlage. Gegenstand der Erfindung ist auch eine Vorrichtung zum Entfernen einer Halbleiterscheibe von einem Poliertuch einer Doppelseiten-Poliermaschine. Das Verfahren ist dadurch gekennzeichnet, daß eine Flüssigkeit durch die Unterlage gegen die auf der Unterlage liegende Halbleiterscheibe gepreßt wird, wobei die Halbleiterscheibe durch das Einwirken der Flüssigkeit von der Unterlage gehoben und anschließend von einer Aufnahmevorrichtung aufgenommen wird.

## Beschreibung

Gegenstand der Erfindung ist ein Verfahren zum Entfernen einer Halbleiterscheibe von einer ebenen Unterlage, insbesondere von einem Poliertuch einer Doppelseiten-Poliermaschine, und eine Vorrichtung zum Entfernen einer Halbleiterscheibe von einem Poliertuch einer Doppelseiten-Poliermaschine.

Die Planarisierung einer Halbleiterscheibe mittels eines chemo-mechanischen Polierverfahrens bildet einen wichtigen Bearbeitungsschritt im Prozeßablauf zur Herstellung einer ebenen, defektfreien und glatten Halbleiterscheibe. Dieser Polierschritt stellt in vielen Fertigungsabläufen den letzten formgebenden und somit die Oberflächeneigenschaften maßgeblich bestimmenden Schritt vor der Weiterverwendung der Halbleiterscheibe als Ausgangsmaterial für die Herstellung elektrischer, elektronischer und mikroelektronischer Bauteile dar. Ziele des Polierverfahrens sind insbesondere das Erreichen einer hohen Ebenheit der Scheibenseiten (Planparallelität), der Abtrag durch Vorbehandlungen geschädigter Oberflächenschichten ("damage removal") und die Reduktion der Mikrorauhigkeit der Halbleiterscheibe. Die beiden Seiten einer Halbleiterscheibe werden unterschieden in eine Rückseite und eine Vorderseite, wobei in der Regel nur die Vorderseite zum Anlegen von Bauelementstrukturen herangezogen wird.

Üblicherweise werden Einseiten- und Doppelseiten-Polierverfahren eingesetzt. Bei der Einseitenpolitur ("single side polishing", SSP) wird nach Montage der Rückseite auf einen geeigneten Träger nur die Vorderseite mit einem auf einen Polierteller gespannten Poliertuch poliert. Bei der Montage wird zwischen der Rückseite und dem Träger eine form- und kraftschlüssige Verbindung, beispielsweise durch Adhäsion, Kleben, Kitten oder Vakuumanwendung, hergestellt. Einseiten-Polierverfahren und -Vorrichtungen sind für die Einzelscheiben-Behandlung ("single wafer polishing") oder für die Behandlung von Gruppen von Scheiben ("batch polishing") üblich. Bei der Doppelseitenpolitur ("double side polishing", DSP) werden Vorderseite und Rückseite gleichzeitig poliert, indem mehrere Halbleiterscheiben zwischen zwei mit Poliertüchern bespannten, oberen und unteren Poliertellern geführt werden. Dabei liegen die Halbleiterscheiben in dünnen Führungskäfigen ("wafer carrier"), die als Läuferscheiben bezeichnet werden und in ähnlicher Form auch beim Läppen von Halbleiterscheiben verwendet werden. Doppelseiten-Polierverfahren und -Vorrichtungen sind stets für die Behandlung von Gruppen von Halbleiterscheiben ausgelegt ("batch polishing").

Die erfolgreiche Herstellung von mikroelektronischen Bauteilen hoher Integrationsdichte stellt extreme Anforderungen an den Grad der Ebenheit, Defektfreiheit und Rauhigkeit der durch Politur hergestellten Halbleiterscheibe. Diese Anforderungen sind am ehesten erfüllt, wenn die Halbleiterscheibe beidseitig poliert ist. Der Vorteil des Vorhandenseins einer polierten Rückseite zusätzlich zu einer polierten Vorderseite beruht unter anderem darauf, daß eine beidseitig polierte Halbleiterscheibe gegenüber einer nur einseitig polierten Halbleiterscheibe sehr viel weniger störende Partikel aufweist, einfacher zu reinigen ist, weniger anfällig für Kontaminationen während ihrer Weiterverarbeitung ist und auch ihre metrologische Meß-, Charakterisier- und Spezifizierbarkeit einfacher ist. Darüber hinaus werden durch die Gleichbehandlung der Seiten Materialspannungen infolge unterschiedlich strukturierter Vorder- und Rückseiten vermieden.

Grundsätzlich kann eine beidseitig polierte Halbleiterscheibe hergestellt werden, indem mit einem Einseiten-Polierverfahren nacheinander die Vorder- und Rückseite poliert werden (sequentielle SSP). Überwiegend verwendetes Verfahren zur Erzielung einer Politur beider Seiten einer Halbleiterscheibe ist jedoch die Doppelseitenpolitur. Die Vorteile der DSP gegenüber der sequentiellen SSP bestehen in dem überlegenen Grad der erzielbaren Ebenheit der Seitenoberflächen, insbesondere hinsichtlich der bei der Weiterverarbeitung maßgeblichen Planparallelität von Vorder- und Rückseite, der kostengünstigeren Duchführbarkeit der Politur sowie dem höheren Durchsatz und der höheren Ausbeute infolge des Fortfalls der bei der sequentiellen SSP notwendigen Montage-, Demontage und Wendeschritte.

Jede Handhabung einer frisch polierten Halbleiterscheibe mit einem mechanisch einwirkenden Handhabungswerkzeug, beispielsweise einem Greifer ("handler"), birgt die Gefahr der Schädigung einer polierten Scheibenoberfläche, beispielsweise dadurch, daß Abdrücke oder Kratzer erzeugt werden. Besonders kritisch sind solche Schädigungen, die die Vorderseite der Halbleiterscheibe betreffen. Frisch polierte Halbleiterscheiben sind auch höchst empfindlich gegenüber einem unkontrollierten, chemischen Angriff, beispielsweise durch ein Ätzmittel. Gefahr für einen solchen Angriff und damit einer Beeinträchtigung der Ebenheit der polierten Oberflächen besteht insbesondere unmittelbar nach einer chemo-mechanischen Politur. Zu diesem Zeitpunkt ist eine weitere chemische Einwirkung des Poliermittels auf die Halbleiterscheibe schädlich und muß möglichst schnell gestoppt werden, beispielsweise durch Überführung der Halbleiterscheibe in ein Spül-, Neutralisations- oder Reinigungsbad.

Im Fall der Einseitenpolitur oder der sequentiellen SSP wird die am Träger montierte Halbleiterscheibe ohne mechanische Einwirkung eines Handhabungswerkzeugs möglichst schnell der Poliervorrichtung entnommen und sofort einer Reinigung, Spülung oder Neutralisation zugeführt. Dieser Verfahrensablauf läßt sich kostengünstig, vollautomatisch und mit hohem Schutz der Halbleiterscheibe vor weiterer chemischer Einwirkung durch das Poliermittel durchführen.

Für die Doppelseitenpolitur ist dieses Entnahmeverfahren nicht verwendbar, weil die dafür notwendige Montage der Halbleiterscheibe auf einem Träger nicht besteht. Es ist zwar üblich, Poliertücher mit unterschiedlichen Haftkoeffizienten zu verwenden, beispielsweise Poliertücher aus verschiedenen Materialien oder mit verschiedenen Texturierungen, damit alle Halbleiterscheiben nach der DSP und dem Entfernen des oberen Poliertellers auf dem unteren Polierteller liegen und nicht wahllos auf die beiden Polierteller verteilt sind. Dennoch scheitert eine Entnahme mit Hilfe eines mechanischen Handhabungswerkzeugs, beispielsweise eines Roboterarms, der eine Halbleiterscheibe nach der anderen durch Ansaugen greift und vom Poliertuch abhebt und in ein Spül- oder Reinigungsbad umsetzt, am Risiko, die Halbleiterscheibe zu zerkratzen oder zu zerbrechen. Die Halbleiterscheibe läßt sich vom Poliertuch erst nach Überwindung starker Adhäsionskräfte (Kapillarkräfte) lösen. Sie sind auf einen Film aus Poliermittel-Resten zurückzuführen, der in einem Spalt zwischen der Halbleiterscheibe und dem Poliertuch eingeschlossen ist. Daher wird üblicherweise jede Halbleiterscheibe manuell vom Poliertuch entfernt, was eine besondere Geschicklichkeit und Sorgfalt erfordert. Der Bediener der Doppelseiten-Poliermaschine muß die auf dem Poliertuch haftende Halbleiterscheibe mit behandschuhten Fingern vorsichtig durch Greifen unter den verrundeten Scheibenrand anheben. Dabei muß die Halbleiterscheibe gezielt auf Biegung beansprucht werden, damit der mit dem Poliermittelfilm belegte Spalt leicht keilförmig erweitert wird, so daß der Poliermittelfilm in den Spalt zurückweicht und die Halbleiterscheibe langsam freigibt. Sofern es die konstruktiven Merkmale der Poliermaschine zulassen, kann die Halbleiterscheibe stattdessen auch auf dem adhäsiven (kapillaren) Poliermittelfilm gleitend, lateral auf dem Poliertuch über den Rand des Poliertellers hinaus verschoben werden. Nachteilig an diesen Methoden der manuellen Scheibenentnahme ist die fortbestehende Gefahr der mechanischen und chemischen Beschädigung der Halbleiterscheibe, die fehlende Automatisierbarkeit der Methoden und die fehlende Einzelscheiben-Verfolgbarkeit. Unter dem zuletzt genannten Begriff versteht man das zunehmend gefragte Erfordernis, die tatsächlichen Herstellungsbedingungen für jede einzelne Halbleiterscheibe im Detail mitverfolgen und aufzeichnen zu können.

Die vorliegende Erfindung löst das Problem, eine Halbleiterscheibe von einer ebenen Unterlage, insbesondere von einem Poliertuch einer Doppelseiten-Poliermaschine, ohne mechanische Beschädigung der Vorder- oder der Rückseite der Halbleiterscheibe in kurzer Zeit und mit der Möglichkeit einer Einzelscheiben-Verfolgung zu entfernen.

Gegenstand der Erfindung ist ein Verfahren, das dadurch gekennzeichnet ist, daß eine Flüssigkeit durch die Unterlage gegen die auf der Unterlage liegende Halbleiterscheibe gepreßt wird, wobei die Halbleiterscheibe durch das Einwirken der Flüssigkeit von der Unterlage gehoben und anschließend von einer Aufnahmevorrichtung aufgenommen wird.

Die Flüssigkeit wird aus einer Gruppe von Flüssigkeiten ausgewählt, die Wasser, wässerige Spül- und Reinigungsmittel, nicht-wässerige Medien, auf eine Weiterbehandlung der Halbleiterscheibe abgestimmte Konditionierungsmittel, beispielsweise Hydrophilierungsmittel, und beliebige Mischungen der genannten Flüssigkeiten umfaßt. Die Aufnahme der durch die Flüssigkeit freigespülten Halbleiterscheibe erfolgt vorzugsweise mit einem Werkzeug, bei dessen Benutzung die Gefahr einer mechanischen Beschädigung der Halbleiterscheibe gering ist. Bevorzugt wird ein Greifwerkzeug verwendet, das nur am Rand der Halbleiterscheibe eingreift und die Vorder- und Rückseite der Halbleiterscheibe nicht berührt, oder ein Aufnahmewerkzeug, das eine Seite der Halbleiterscheibe ansaugt. Besonders bevorzugt ist es, eine Aufnahmevorrichtung vorzusehen, mit der es möglich ist, das Entfernen der Halbleiterscheibe von der Unterlage automatisch durchzuführen. Eine derartiges Verfahren und eine dafür geeignete Aufnahmevorrichtung werden nachfolgend an Hand einer Vorrichtung zum Entfernen einer Halbleiterscheibe von einem Poliertuch einer Doppelseiten-Poliermaschine näher beschrieben.

Diese Vorrichtung ist ebenfalls Gegenstand der Erfindung und gekennzeichnet durch einen Polierteller, der mit Flüssigkeitsdurchführungen versehen ist, die in zur Halbleiterscheibe weisenden Austrittsbohrungen im Poliertuch münden, und durch eine Aufnahmevorrichtung für die Halbleiterscheibe, die eine zylinderförmige Führung und eine Sperrvorrichtung aufweist, die in einem aktivierten Zustand ein Zurückfallen der Halbleiterscheibe auf das Poliertuch verhindert.

Das Verfahren und die Vorrichtung bewirken in einem ersten Schritt ein berührungsloses Freispülen der Halbleiterscheibe durch Erweiterung des kapillaren Spaltes zwischen der Halbleiterscheibe und dem Poliertuch. Dies wird durch Einpressen einer geeigneten Flüssigkeit durch Flüssigkeitsdurchführungen im unteren Polierteller und Austrittsbohrungen im Poliertuch erreicht. In einem weiteren Schritt wird die Halbleiterscheibe durch den Flüssigkeitsdruck in einen zylinderförmigen Aufnahmebehälter gehoben und dabei weiterhin von der Flüssigkeit umspült. Die Innenwand des Aufnahmebehälters fungiert als zylinderförmige Führung für den Rand der Halbleiterscheibe. Der Aufnahmebehälter weist eine Sperrvorrichtung auf, die ein Zurückfallen der Halbleiterscheibe auf das Poliertuch nach Verminderung des Flüssigkeitsdrucks verhindert.

Das Verfahren und die Vorrichtung zeichnen sich insbesondere dadurch aus, daß die Halbleiterscheibe ohne mechanische Handhabung und vorzugsweise unter Verwendung einer sie nicht in unkontrollierbarer Weise chemisch angreifenden Flüssigkeit freigespült wird. Weiterhin erfolgt die Aufnahme der Halbleiterscheibe in den zylinderförmigen Aufnahmebehälter nur durch Führen des Randes der Halbleiterscheibe. Zwischen dem Rand und der Innenwand des Aufnahmebehälters befindet sich stets ein Flüssigkeitsfilm, wodurch eine direkte mechanische Berührung von Halbleiterscheibe und Aufnahmewerkzeug vermieden wird. Darüber hinaus kann die Halbleiterscheibe langsam und unter fortgesetzter Umspülung durch die Flüssigkeit auf die Sperrvorrichtung sinken und muß nicht durch ein Werkzeug spontan "gegriffen" werden. Das gesamte Verfahren vom Freispülen bis zur Aufnahme der Halbleiterscheibe im Aufnahmebehälter erfolgt somit unter durchgängiger Spülung der Halbleiterscheibe ("wet-in-wet handling"). Des weiteren kann die Halbleiterscheibe unverzüglich nach dem Ende der Politur vom Poliertuch gehoben und von Poliermittel-Resten befreit werden, da die Läuferscheibe, in deren Bohrung sie liegt, zuvor nicht entfernt werden muß. Schließlich ermöglicht das Verfahren eine eindeutige, nachvollziehbare Scheiben-Positions-Zuordnung, so daß eine Einzelscheiben-Verfolgung auch im Anschluß an das eigentliche Polieren auf einfache Weise möglich ist.

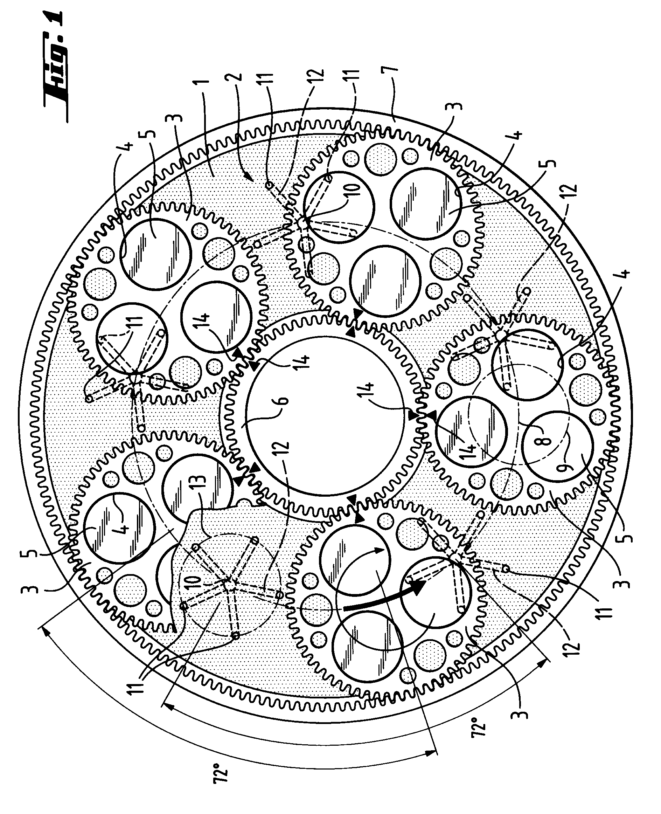

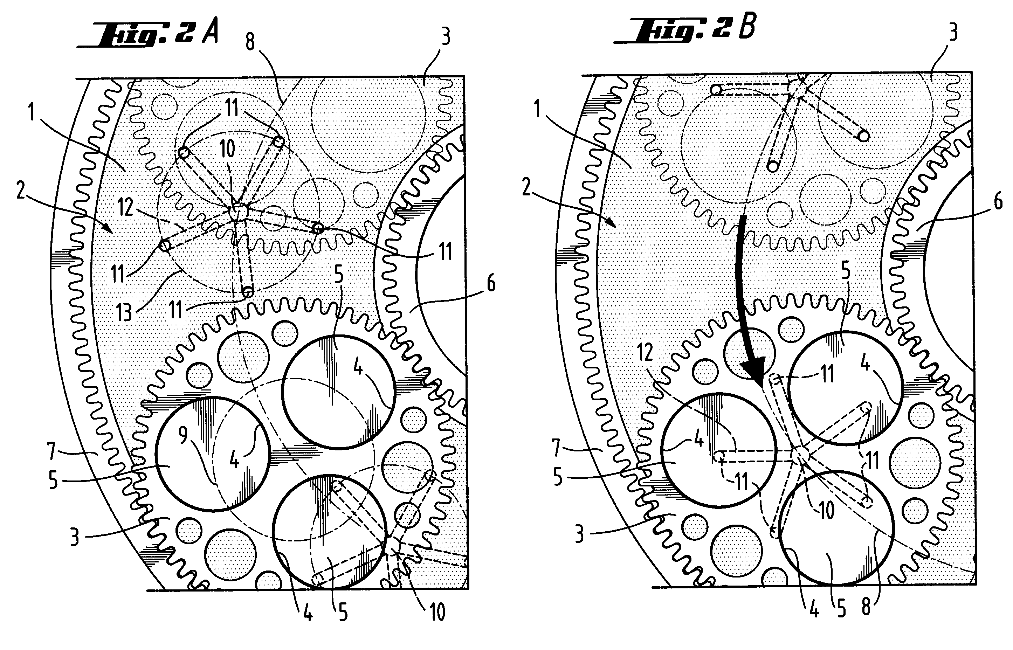

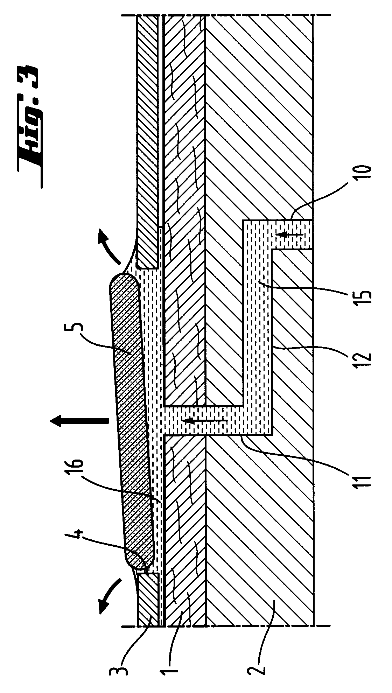

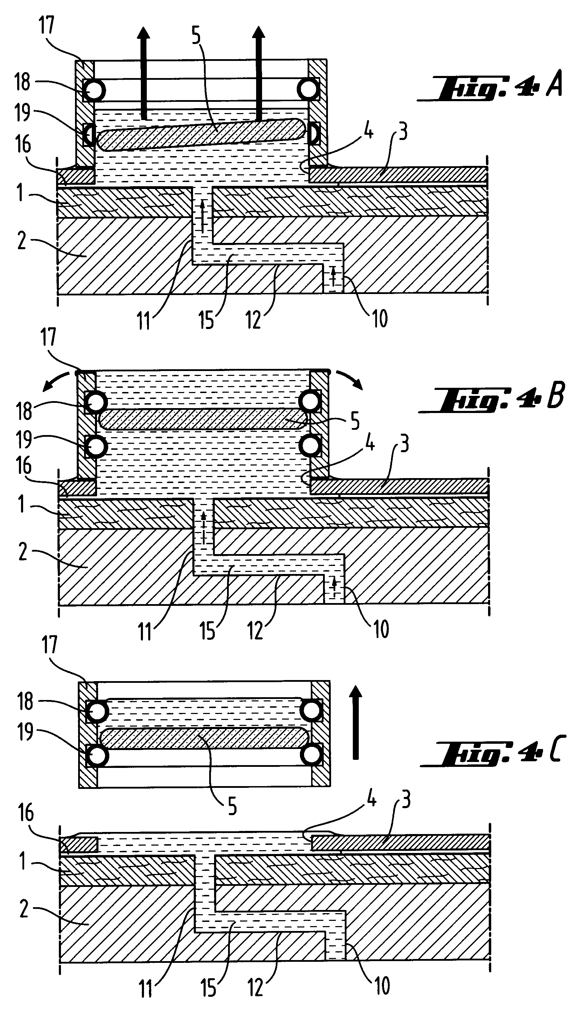

Die Erfindung wird nachfolgend an Hand von Figuren näher beschrieben. Die Darstellungen dienen nur zur Veranschaulichung der Erfindung und zeigen nur Merkmale eines bevorzugten Ausführungsbeispiels. Figur 1 zeigt schematisch die Aufsicht auf den unteren Polierteller einer Doppelseiten-Poliermaschine. Der obere Polierteller ist aus Gründen der Einfachheit nicht dargestellt. In den Figuren 2A und 2B ist aus der gleichen Perspektive ein Teilausschnitt des Poliertellers dargestellt. Die Figur 3 zeigt einen Teilquerschnitt durch den unteren Polierteller. In den Figuren 4A-4C ist zusätzlich zu den in Fig. 3 gezeigten Merkmalen ein weiteres Merkmal der Erfindung dargestellt.

Zunächst wird auf die Figur 1 Bezug genommen. Auf dem mit einem Poliertuch 1 bespannten Polierteller 2 liegen gezähnte Läuferscheiben 3 mit Bohrungen 4 auf, in die Halbleiterscheiben 5 eingelegt sind. Das dargestellte Beispiel ist so gewählt, daß auf dem Polierteller fünf Läuferscheiben Platz finden, wobei jede Läuferscheibe in ihren Bohrungen in einer typischerweise symmetrischen Anordnung drei Halbleiterscheiben aufnehmen kann. Die Zähne der Läuferscheiben greifen in einen inneren Zahnkranz 6 und in einen äußeren Zahnkranz 7 ein. Die Kinematik der Doppelseitenpolitur wird durch die verknüpften Bewegungen von Drehung der Läuferscheiben (durch stark gekrümmten dicken Pfeil dargestellt) und Translation der Läuferscheiben (durch schwach gekrümmten dicken Pfeil dargestellt) sowie der das Poliertuch tragenden Tellerdrehung(en) (nicht dargestellt) beschrieben. Während der Politur bewegen sich die Mittelpunkte der Läuferscheiben gleichförmig auf einer großen Kreisbahn 8 um den Mittelpunkt des Poliertellers, und die Mittelpunkte der Halbleiterscheiben einer Läuferscheibe auf einer kleinen Kreisbahn 9 um den Mittelpunkt der Läuferscheibe (nur an einer Läuferscheibe gezeigt, wobei die Konturen der Läuferscheiben des besseren Verständnisses wegen nur andeutungsweise dargestellt sind).

Wesentliches Merkmal der Vorrichtung sind Flüssigkeitsdurchführungen 10 durch den Polierteller, die in Austrittsbohrungen 11 im Poliertuch münden. Zu jeder Läuferscheibe gehört ein Bündel 12 von Austrittsbohrungen, die auf einem der kleinen Kreisbahn 9 entsprechenden Kreis 13 liegen müssen. Die Bündel von Austrittsbohrungen müssen außerdem in Anzahl und Winkelverteilung der Anzahl und der relaltiven Position der Läuferscheiben übereinstimmen. Den im Ausführungsbeispiel dargestellten fünf Läuferscheiben, die vorteilhafterweise jeweils unter einem Winkel von 360°:5 = 72° zueinander angeordnet sind, sind daher fünf Bündel von Austrittsbohrungen zugeordnet, wobei die Winkel zwischen den Bündeln ebenfalls 72° betragen.

Die Läuferscheiben werden beim ersten und nur einmalig erforderlichen Einlegen auf den Polierteller entsprechend der Verteilung der Bündel von Austrittsbohrungen ausgerichtet. Zweckmäßigerweise geschieht dies mit Hilfe von korrespondierenden Markierungsmarken 14 auf dem inneren Zahnkranz 6 oder dem Polierteller und der jeweiligen Läuferscheibe. Bei dem dargestellten Ausführungsbeispiel mit drei Halbleiterscheiben pro Läuferscheibe sollte eine Anzahl von mindestens fünf Austrittsbohrungen pro Bündel bereitgestellt werden, um sicherzustellen, daß in jedem Fall mindestens eine Austrittsbohrung unter eine Halbleiterscheibe der Läuferscheibe zu liegen gebracht werden kann. Um alle Halbleiterscheiben auf erfindungsgemäße Weise vom Polierteller entfernen zu können, müssen die Kreise 13, auf denen jeweils ein Bündel von Austrittsbohrungen liegt, und die kleinen Kreisbahnen 9, die der Bewegung der Mittelpunkte der Halbleiterscheiben einer Läuferscheibe entsprechen, paarweise zur Deckung gebracht werden. Dies kann entweder durch Nachführen der Winkelposition des Poliertellers 2 oder durch weitere Translation der Läuferscheiben geschehen und beispielsweise mit Hilfe bekannter vektorgesteuerter Servomotoren am Ende der Polierfahrt automatisch erfolgen. In den Figuren 2A und 2B ist eine derartige Bewegung schematisch dargestellt. Fig. 2A zeigt eine Situation, bei der sich die Austrittsbohrungen 11 noch nicht in der vorgesehenen Position befinden. In der Darstellung gemäß Figur 2B ist dies der Fall und die Halbleiterscheiben können erfindungsgemäß vom Poliertuch entfernt werden, weil sich unabängig vom Eigendrehwinkel der Läuferscheibe mindestens eine Austrittsbohrung unter jeder Halbleiterscheibe befindet.

Das Prinzip des Freispülens einer in die Bohrung 4 einer Läuferscheibe 3 eingelegten Halbleiterscheibe 5 durch Einpressen einer geeigneten Flüssigkeit 15 in den Spalt 16 zwischen Poliertuch 1 und Halbleiterscheibe 5 ist in Figur 3 gezeigt. Durch Pressen von Flüssigkeit durch die Flüssigkeitsdurchführung 10 und die Austrittsbohrungen 11 im Poliertuch wird der Spalt 16 erweitert. Gleichzeitig wird die Halbleiterscheibe 5 angehoben (durch dicken Pfeil dargestellt) und von Flüssigkeit 15 umspült. Überschüssige Flüssigkeit entweicht durch die Öffnung zwischen dem Rand der Halbleiterscheibe und der Bohrung in der Läuferscheibe (durch gekrümmte Pfeile dargestellt).

Es ist prinzipiell möglich, die Flüssigkeit durch oder entlang der Achse des unteren Poliertellers an die Flüssigkeitsdurchführungen 10 heranzuführen. Allerdings besteht durch den dafür notwendigen Kontakt der Flüssigkeit mit bewegten Teilen die Gefahr einer Verunreinigung der Flüssigkeit, die sich auf die Halbleiterscheibe übertragen könnte. Es ist daher bevorzugt, die Flüssigkeit drucklos an den unteren Polierteller heranzuführen und über ein Gerinne in eine mit dem Polierteller verbundene ringförmige Auffangwanne zu leiten. Die Auffangwanne kann beispielsweise innerhalb des inneren Zahnkranzes oder außerhalb des Außenumfanges des Poliertellers angeordnet sein. Von der Auffangwanne wird die Flüssigkeit mit Hilfe von Pumpen, vorzugsweise Membran-Dosierpumpen, die mit dem Polierteller mitrotieren, mit Druck beaufschlagt und an die jeweiligen Flüssigkeitsdurchführungen herangeführt.

Sobald eine Halbleiterscheibe, wie in Figur 3 dargestellt, freigespült ist, kann sie mit einem Aufnahmewerkzeug, beispielsweise mit einem Greifwerkzeug, das am Rand der Halbleiterscheibe eingreift, oder mit einer Vakuumpinzette, die die freie Seite der Halbleiterscheibe ansaugt, aufgenommen werden. Bei dieser Art der Scheibenaufnahme ist es vorteilhaft, in den Austrittsöffnungen vorgespannte Rückschlagventile vorzusehen, die sich bei Druckabfall selbstständig schließen. Solche Ventile verhindern, daß eine freigespülte Halbleiterscheibe aus der Bohrung der Läuferscheibe geschleudert wird.

In einer besonders bevorzugten Ausgestaltungsform der Erfindung wird die Halbleiterscheibe automatisch freigespült und mit Hilfe einer ebenfalls automatisch arbeitenden Aufnahmevorrichtung aufgenommen. Die Aufnahmevorrichtung und ihr Funktionsprinzip ist in den Figuren 4A - 4C gezeigt.

Noch vor dem Freispülen der Halbleiterscheibe 5 wird ein zylinderförmiger Entnahmekopf 17, dessen Durchmesser dem Innendurchmesser der Bohrung 4 in der Läuferscheibe 3 entspricht und geringfügig größer als der Außendurchmesser der Halbleiterscheibe ist, zentrisch über der Halbleiterscheibe 5 auf der Läuferscheibe 3 abgesetzt (Fig. 4A). Dabei entsteht eine form- und kraftschlüssige Verbindung zwischen dem Entnahmekopf und der Läuferscheibe, so daß die Flüssigkeit beim Freispülen der Halbleiterscheibe in den Entnahmekopf geleitet wird. Die Zentrierung des Entnahmekopfes kann beispielsweise durch Führungsbohrungen in der Läuferscheibe und dazu passende Zentrierstifte am Entnahmekopf erleichtert werden. Der abgesetzte Entnahmekopf fixiert die Läuferscheibe auf dem Polierteller, so daß sie nicht aufschwimmen kann, selbst wenn darunter zufälligerweise auch eine Austrittsöffnung zu liegen gekommen ist.

Nachdem die Aufnahme der Halbleiterscheibe auf diese Weise vorbereitet worden ist, wird die Halbleiterscheibe durch Zuführen von Flüssigkeit durch die Flüssigkeitsdurchführung 10 und die Austrittsbohrung 11, wie bereits beschrieben, in den Spalt 16 zwischen der Halbleiterscheibe 5 und dem Poliertuch 1 gepreßt, wobei die Halbleiterscheibe durch den Flüssigkeitsdruck vom Poliertuch angehoben wird und beginnt, in den Entnahmekopf zu wandern (Fig. 4A). Nachströmende Flüssigkeit drückt die Halbleiterscheibe weiter in den Entnahhmekopf hinauf bis zu einer aktivierten, oberen Sperrvorrichtung 18, durch die der Innendurchmesser des Entnahmekopfs soweit verengt ist, daß die Halbleiterscheibe an ihrem Rand gehindert wird, die aufwärts gerichtete Bewegung fortzusetzen. Weiter nachströmende Flüssigkeit tritt am offenen oberen Ende des Entnahmekopfes aus (durch gekrümmte Pfeile dargestellt). Sobald die Halbleiterscheibe die obere Sperrvorrichtung 18 erreicht hat, ist vorgesehen, die Flüssigkeitszufuhr zu reduzieren (durch gestrichelte Pfeile dargestellt) und gleichzeitig eine untere Sperrvorrichtung 19, die die Halbleiterscheibe während ihrer Aufwärtsbewegung passiert hat, zu aktivieren (Fig. 4B). Danach ist die Halbleiterscheibe im Entnahmekopf 17 gefangen und kann nicht mehr auf das Poliertuch 1 zurückfallen.

Als Sperrvorrichtung besonders geeignet sind Schläuche oder Balge (Haltewulste), die in einem nicht aktivierten, drucklosen Zustand ringförmig um die Innenwand des Entnahmekopfes laufen und bündig mit der Innenwand abschließen. Ihre Aktivierung erfolgt pneumatisch, beispielsweise durch Füllen mit Feinluft, oder hydraulisch, beispielsweise durch Füllen mit Wasser. Dabei dehnen sie sich in den Entnahmekopf aus und verengen ihn, so daß sein Innendurchmesser an der betroffenen Stelle kleiner als der Durchmesser der Halbleiterscheibe wird. Alternativ können jede Art magnetisch, elektromotorisch, pneumatisch oder hydraulisch aktivierbare Sperrklinken anstelle von Haltewulsten verwendet werden. Eine Sperrvorrichtung sollte jedoch mindestens drei solcher Sperrklinken aufweisen, die gleichmäßig voneinander beabstandet sind, so daß der Rand der Halbleiterscheibe an drei von den Sperrklinken bereitgestellten Stützstellen abgestützt wird. Mit dem Vorteil besonderer Betriebssicherheit kann auch ein in einer Nut im Entnahmekopf umlaufender, im drucklosen, verkürzten Zustand aus der Nut in den Entnahmekopf herausragender geteilter Ring dehnbaren Materials verwendet werden. In diesem Zustand wirkt der Ring als aktivierte Sperrvorrichtung. Erst nach beispielsweise hydraulischer oder pneumatischer Druckanwendung wird der Ring soweit gedeht, daß er vollständig in der Nut verschwindet. Da sich der Ring ohne Energiezufuhr im drucklosen, die Halbleiterscheibe zurückhaltenden Zustand befindet, ist ein Herausfallen der Halbleiterscheibe aus dem Entnahmekopf beispielsweise nach pötzlichem Strom- oder Flüssigkeitsausfall nicht möglich. Ein ähnliches Sicherheitskonzept läßt sich auch bei Verwendung von Haltewulsten oder Sperrklinken erreichen, beispielsweise indem diese Sperrvorrichtungen durch Anlegen eines Vakuums im nicht sperrenden Zustand gehalten werden.

Der Entnahmekopf 17 wird schließlich mit der am Zurückfallen zum Poliertuch gehinderten Halbleiterscheibe 5 angehoben (Figur 4C). Gleichzeitig wird die Zufuhr weiterer Flüssigkeit eingestellt, um ein Aufschwimmen der nun nicht mehr niedergehaltenen Läuferscheibe zu vermeiden. Im Entnahmekopf unterbleibt wegen des Fortfalls der Zufuhr von Flüssigkeit der hydrodynamische Auftrieb der Halbleiterscheibe. Diese wird nun nicht mehr gegen die obere Sperrvorrichtung 18 gedrückt, sondern sinkt langsam abwärts, bis sie von der unteren Sperrvorrichtung 19 gebremst wird.

Die Halbleiterscheibe wird dem Entnahmekopf entnommen, indem die untere Sperrvorrichtung deaktiviert wird. Die Halbleiterscheibe fällt daraufhin aus dem Entnahmekopf heraus und steht der jeweils beabsichtigten Weiterbehandlung zur Verfügung. Auf diese Weise kann die Halbleiterscheibe beispielsweise einem kommerziellen Naßeinhorder mit Scheibenzuführung per Wasserrutsche und Horden-Indexer zugeführt werden.

Das Freispülen polierter Halbleiterscheiben vom Poliertuch und ihre Aufnahme in einer Aufnahmevorrichtung wird vorzugsweise vollautomatisch durchgeführt. Die in den Läuferscheiben liegenden Halbleiterscheiben werden nach einem vorbestimmten Plan freigespült und aufgenommen. Bevorzugt ist, in Bezug auf die vorhandenen Läuferscheiben eine sequentielle Entnahme-Reihenfolge einzuhalten. Dabei wird eine Läuferscheibe nach der nächstliegenden durch synchrones Weitertakten des Poliertellers in eine ortsfeste Entnahmeposition gefahren. Zur Erhöhung der Entnahmegeschwindigkeit wird vorgeschlagen, die Halbleiterscheiben einer Läuferscheibe zeitgleich freizuspülen und aufzunehmen. Zu diesem Zweck werden so viele Entnahmeköpfe zu einer Einheit verbunden und gleichzeitig betrieben, wie Scheiben in der Läuferscheibe eingelegt sind.

## Patentansprüche

1. Verfahren zum Entfernen einer Halbleiterscheibe von einer ebenen Unterlage, insbesondere von einem Poliertuch einer Doppelseiten-Poliermaschine, dadurch gekennzeichnet, daß eine Flüssigkeit durch die Unterlage gegen die auf der Unterlage liegende Halbleiterscheibe gepreßt wird, wobei die Halbleiterscheibe durch das Einwirken der Flüssigkeit von der Unterlage gehoben und anschließend von einer Aufnahmevorrichtung aufgenommen wird.

2. Verfahren nach Anspruch 1, dadurch gekennzeichnet, daß die Halbleiterscheibe von der Flüssigkeit in einen Aufnahmebehälter gespült wird und verhindert wird, daß die Halbleiterscheibe auf die Unterlage zurückfallen kann.

3. Verfahren nach Anspruch 1 oder Anspruch 2, dadurch gekennzeichnet, daß das Anheben der Halbleiterscheibe und das Spülen der Halbleiterscheibe in den Aufnahmebehälter automatisiert erfolgt.

4. Verfahren nach Anspruch 1, dadurch gekennzeichnet, daß die Halbleiterscheibe mit einem Aufnahmewerkzeug aufgenommen wird, wobei die Halbleiterscheibe nur in einem Randbereich berührt wird.

5. Verfahren nach Anspruch 1, dadurch gekennzeichnet, daß die Halbleiterscheibe aufgenommen wird, indem eine Seite der Halbleiterscheibe mit einem Aufnahmewerkzeug angesaugt wird.

6. Vorrichtung zum Entfernen einer Halbleiterscheibe von einem Poliertuch einer Doppelseiten-Poliermaschine, gekennzeichnet durch einen Polierteller, der mit Flüssigkeitsdurchführungen versehen ist, die in zur Halbleiterscheibe weisenden Austrittsbohrungen im Poliertuch münden, und durch eine Aufnahmevorrichtung für die Halbleiterscheibe, die eine zylinderförmige Führung und eine Sperrvorrichtung aufweist, die in einem aktivierten Zustand ein Zurückfallen der Halbleiterscheibe auf das Poliertuch verhindert.

7. Vorrichtung nach Anspruch 6, dadurch gekennzeichnet, daß die Sperrvorrichtung pneumatisch, hydraulisch, elektromotorisch, magnetisch oder durch Anlegen eines Vakuums aktiviert oder deaktiviert wird.
